**Europäisches Patentamt**

**European Patent Office**

**Office européen des brevets**

(19)

(11) Veröffentlichungsnummer: **0 153 963**
**B1**

## (12) EUROPÄISCHE PATENTSCHRIFT

(45) Veröffentlichungstag der Patentschrift:
21.06.89

(21) Anmeldenummer: 84101092.6

(22) Anmeldetag: 18.02.84

(51) Int. Cl.⁴: **H 01 J 37/295,** G 01 N 23/207

(54) Einrichtung zur Beobachtung von gestreuten Elektronen.

(43) Veröffentlichungstag der Anmeldung:
11.09.85 Patentblatt 85/37

(45) Bekanntmachung des Hinweises auf die Patenterteilung:
21.06.89 Patentblatt 89/25

(84) Benannte Vertragsstaaten:
CH DE FR GB IT LI

(56) Entgegenhaltungen:
EP-A-0 067 152
EP-A-0 138 610
US-A-3 445 706

JOURNAL OF APPLIED PHYSICS, Band 48, Nr. 12,
Dezember 1977, Seiten 5027-5032, American Institute
of Physics, New York, US; C. BERGER et al.:
"Preliminary study for the construction of a lowenergy electron-diffraction apparatus using a hightension source"
JOURNAL OF PHYSICS E; SCIENTIFIC
INSTRUMENTS, Band 6, Nr. 10, Oktober 1973,
Seiten 1029-1032, London, GB; R.S. ZIMMER: "LEED
apparatus: design for high-fidelity diffraction
patterns in a strong magnetic field"

(73) Patentinhaber: **LEYBOLD AKTIENGESELLSCHAFT,**
**Bonner Str. 504, D-5000 Köln 51 (DE)**

(72) Erfinder: **Henzler, Martin, Prof. Dr., Finkenweg 6,**
**D-3006 Garbsen 5 (DE)**
Erfinder: **Bartha, Johann Wolfgang, Dr.,**
**Deichmannstrasse 1, D-3000 Hannover 1 (DE)**

(74) Vertreter: **Leineweber, Jürgen, Dipl.- Phys.,**
**Nagelschmiedshütte 8, D-5000 Köln 40 (DE)**

## Beschreibung

Die Erfindung bezieht sich auf eine Einrichtung zur Beobachtung von an einer Probe gestreuten Elektronen für die Untersuchung von Kristalloberflächen nach der LEED-Technik mit einer Elektronenquelle, Mitteln zur Sichtbarmachung oder Registrierung der gestreuten Elektronen und mit einer der Probe unmittelbar vorgelagerten elektronenoptischen Einrichtung, durch die sowohl die Primärelektronen als auch die gestreuten Elektronen hindurchtreten.

Bei der LEED-Technik (Low Energy Electron Diffraction) wird die Kristalloberfläche mit niederenergetischen Elektronen (20 bis 500 eV) beschossen. An den Strukturen der Kristalloberflächen treten Beugungserscheinungen auf, die zu Streuungen mit bevorzugten Richtungen führen. Die Feststellung dieser bevorzugten Richtungen kann durch Messung der Winkelverteilung der gestreuten Elektronen erfolgen. Eine andere Methode besteht darin, die gestreuten Elektronen mit Hilfe eines Leuchtschirmes sichtbar zu machen. Bei einer regelmäßigen Struktur der Kristalloberfläche entstehen regelmäßige Beugungsbilder, die sich aus einzelnen Beugungsreflexen zusammensetzen. Bei Abweichungen von der Regelmäßigkeit liegen Defekte der Oberflächenstruktur vor.

Bei Einrichtungen der eingangs genannten Art haben zwei Parameter Einfluß auf die Meßgenauigkeit. Zum einen ist eine möglichst scharfe Fokussierung des Elektronenstrahls von der Kathode (genauer "crossover") auf den Leuchtschirm oder Detektor wünschenswert. Zum anderen ist die Erhaltung der (möglichst großen) Beugungswinkel zwischen den Beugungsreflexen zweckmäßig.

Aus Journal of Applied Physics, 48, 1977, S. 5027, ist eine Einrichtung der eingangs genannten Art bekannt. Der Probe unmittelbar vorgelagert ist ein Johansson-Objektiv. Bei einem Objektiv dieser Art ist die Probe Bestandteil der Linse und liegt ebenso wie die Kathode auf einem relativ hohen negativen Potential. Die Erhaltung möglichst großer Beugungswinkel zwischen den Beugungsreflexen ist dabei nicht möglich, da die Beugungswinkel durch die Hochspannung (etwa proportional zur Wurzel der Nachbeschleunigung in der Immersionslinse) verringert werden.

Bei einer weiteren bekannten Einrichtung ist der Elektronenquelle eine elektronenoptische Linse unmittelbar vorgelagert, um die Elektronen auf den Leuchtschirm fokussieren zu können. Sowohl die Elektronenquelle als auch die elektronenoptische Linse sind hinter dem Leuchtschirm angeordnet. Die Elektronen gelangen durch eine Öffnung im Leuchtschirm auf die Probe und werden von dort in Richtung auf den Leuchtschirm zurückgestreut. Der Weg, den die Elektronen nach dem Verlassen der elektronenoptischen Linse zurücklegen, entspricht also etwa der doppelten Größe des Leuchtschirmradius, welche üblicherweise zwischen 7 und 20 cm liegt. Praktisch bedeutet das, daß auf dem Leuchtschirm ein vergrößertes Abbild der Kathode als kleinster Fokus erscheint. Demzufolge haben die Beugungsreflexe auf dem Leuchtschirm bestenfalls Durchmesser von 0,5 bis 2 mm, so daß schwache Reflexe wegen eines zu geringen Kontrastes nicht mehr beobachtbar sind. Besonders nachteilig ist, daß bei der geringen Schärfe Verbreiterungen der Reflexe aufgrund von Defekten nur bei großer Dichte beobachtbar sind. Auch bei vorbekannten Einrichtungen, bei denen die Winkelverteilung der gestreuten Elektronen mit Hilfe eines Detektors festgestellt wird, hängt die Auflösung des Systems von der Qualität der Fokussierung des "crossover" auf den Detektor ab.

Der vorliegenden Erfindung liegt die Aufgabe zugrunde, bei einer Einrichtung der eingangs genannten Art die beiden die Meßgenauigkeit beeinflussenden Parameter (scharfe Fokussierung, Erhaltung der Beugungwinkel) zu optimieren.

Erfindungsgemäß wird diese Aufgabe dadurch gelöst, daß die der Probe unmittelbar vorgelagerte elektronenoptische Einrichtung eine Linse ist, die mindestens zwei Ringblenden umfaßt, von denen die der Probe benachbarte Elektrode auf Erdpotential liegt, um die Probe nahezu feldfrei zu halten. Bei einer elektronenoptischen Einrichtung dieser Art findet eine Abbremsung der Elektronen vor der Probe und eine Nachbeschleunigung auf dem Rückweg nicht mehr statt, so daß die Beugungswinkel nicht mehr verringert werden. Gleichzeitig befindet sich die Linse auf dem abbildungsmäßig besten Platz, so daß eine scharfe Fokussierung des Elektronenstrahls von der Kathode auf den Leuchtschirm oder Detektor möglich ist. Infolge dieser Verbesserung des Fokus wird bei gleichem Abstand von der Probe zum Detektor die Auflösung des Systems zum Nachweis von Kristallfehlern um mindestens den Faktor 3 gesteigert. Gleichzeitig ist damit eine Kontraststeigerung mindestens um den Faktor 9 verbunden, so daß schwächere Reflexe auf einem Leuchtschirm besser sichtbar sind bzw. sich besser vom Untergrund abheben. Erfolgt die Feststellung oder Messung der Winkelverteilung der gestreuten Elektronen mit Hilfe eines Detektors, dann ist wegen des wesentlich kleineren Fokus eine verbesserte Auslösung erzielbar. Der Durchmesser der Eintrittsöffnung des Detektors kann wesentlich kleiner gewählt werden, und zwar von dem bisher üblichen Durchmesser von 1 mm auf 30 µm.

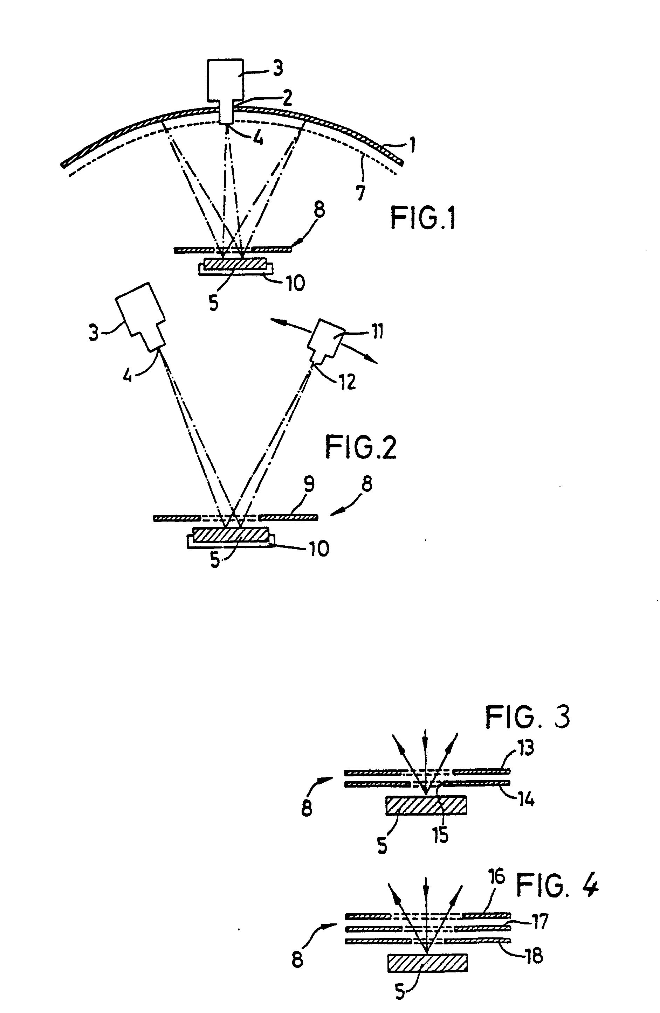

Weitere Vorteile und Einzelheiten der Erfindung sollen anhand von in den Figuren 1 bis 4 dargestellten Ausführungsbeispielen erläutert werden.

Fig. 1 zeigt eine Anordnung mit einem Leuchtschirm 1, der in seinem Zentrum eine Öffnung 2 für den Durchtritt der Primärelektronen aufweist. Die schematisch dargestellte Elektronenquelle ist mit 3 bezeichnet, der "crossover" der Elektronen mit 4. Von der Quelle 3 gelangen die Elektronen zur Probe 5, die auf der Probenhalterung 10 befestigt ist, und werden dort unter bevorzugten Winkeln gestreut bzw. "gebeugt". Auf dem Leuchtschirm 1 erzeugen diese zurückgestreuten Elektronen die gewünschten Beugungsbilder, die Rückschlüsse auf die Struktur der Kristalloberfläche zulassen. In bekannter Weise ist dem Leuchtschirm 1 ein Gitter 7 vorgelagert. Es verhindert, daß gestreute Elektronen mit zu niedrigen Energien den Leuchtschirm erreichen.

Vor der Probe 5 ist die erfindungsgemäße elektronenoptische Linse 8 derart angeordnet, daß sowohl die Primärelektronen als auch die gestreuten Elektronen durch sie hindurchtreten. Sie besteht aus wenigstens zwei Ringblenden wie gezeigt in den figuren 3 und 4, deren Potential so gewählt ist, daß eine Vergrößerung des "crossover" auf dem Weg der Elektronen von der Quelle 3 zum Leuchtschirm 1 nicht eintritt.

Fig. 2 zeigt ein Ausführungsbeispiel, bei dem an Stelle des Leuchtschirms 1 ein um die Probe 5 verschwenkbarer Detektor 11 vorgesehen ist, mit dem die Messung der Winkelverteilung der gestreuten Elektronen erfolgt. Auch bei dieser Anordnung ist die erfindungsgemäße Linse 8 vorgesehen, die die Elektronen auf die Eintrittsöffnung 12 des Detektors 11 fokussiert. Auf eine Verschwenkung des Detektors 11 kann verzichtet werden, wenn ein an sich bekanntes Ablenksystem verwendet wird, mit dem unter verschiedenen Winkeln an der Probe 5 gestreute Elektronen wahlweise auf die Eintrittsöffnung des Detektors abgebildet werden können.

Die Figuren 3 und 4 zeigen unterschiedliche Ausführungsformen für die elektronenoptische Linse 8. Beim Ausführungsbeispiel nach Fig. 3 sind zwei Blenden 13 und 14 dieser Art vorgesehen. Die der Probe unmittelbar benachbarte Elektrode 14 liegt zweckmäßigerweise auf Erdpotential. Ihre zentrale Öffnung 15 ist möglichst klein gewählt, um die Oberfläche der Probe 5 möglichst feldfrei zu halten.

Fig. 4 zeigt drei ringblendenförmige Elektroden 16, 17 und 18 mit jeweils den Positionen der Elektronenstrahlen angepaßten zentralen Öffnungen. Bei dieser Ausführungsform haben sich die folgenden Daten und Abmessungen als besonder zweckmäßig erwiesen: Beträgt die Energie der Elektronen 100 eV, dann sollten die Elektroden untereinander einen Abstand von je etwa 2 mm haben. Die Probe 5 kann von der Elektrode 18 2 bis 5 mm entfernt sein. Die Elektroden 16 und 18 liegen auf Erdpotential, während das an Elektrode 17 anliegende Potential 60 bis 80 V beträgt. Die zentralen Öffnungen der ringblendenförmigen Elektroden 16 bis 18 nehmen - von der Probe 5 ausgehend - von 10 auf 20 mm zu.

## Patentansprüche

1. Einrichtung zur Beobachtung von an einer Probe gestreuten Elektronen für die Untersuchung von Kristalloberflächen nach der LEED-Technik mit einer Elektronenquelle, Mitteln zur Sichtbarmachung oder Registrierung der gestreuten Elektronen und mit einer der Probe unmittelbar vorgelagerten elektronenoptischen Einrichtung, durch die sowohl die Primärelektronen als auch die gestreuten Elektronen hindurchtreten, dadurch gekennzeichnet, daß die elektronenoptische Einrichtung eine Linse (8) ist, die mindestens zwei Ringblenden (13, 14 bzw. 16, 17, 18) umfaßt, von denen die der Probe benachbarte Elektrode (14, 18) auf Erdpotential liegt, um die Probe nahezu feldfrei zu halten.

2. Einrichtung nach Anspruch 1, dadurch gekennzeichnet, daß die elektronenoptische Linse (8) von drei Ringblenden (16, 17, 18) gebildet wird, von denen die äußeren (16, 18) auf Erdpotential liegen.

3. Einrichtung nach Anspruch 1 oder 2, dadurch gekennzeichnet, daß die Größe der zentralen Öffnungen der Ringblenden (13, 14 bzw. 16, 17, 18) von der Probe (5) ausgehend zunimmt.

## Claims

1. Device for the observation of electrons scattered at a specimen for investigating crystal surfaces according to the LEED technique, comprising an electron source, means for visualizing or recording the scattered electrons and an electron-optical device which is mounted directly in front of the specimen and through which both the primary electrons and the scattered electrons pass, characterised in that the electron-optical device is a lens (8) which comprises at least two annular diaphragms (13, 14 or 16, 17, 18), of which the electrode (14, 18) adjacent to the specimen is at earth potential, in order to keep the specimen almost fieldfree.

2. Device according to claim 1, characterised in that the electron-optical lens (8) is formed by three annular diaphragms (16, 17, 18), the outer (16, 18) of which are at earth potential.

3. Device according to claim 1 or 2, characterised in that the size of the central apertures of the annular diaphragms (13, 14 or 16, 17, 18) increases from the specimen (5) outwards.

## Revendications

1. Dispositif pour l'observation d'électrons dispersés sur un échantillon en vue de l'examen de surfaces de cristaux selon la technique de diffraction d'électrons à faible énergie (technique LEED), comprenant une source d'électrons, des moyens pour visualiser ou enregistrer les électrons dispersés et un dispositif d'optique électronique placé directement devant l'échantillon et qui est traversé à la fois par les électrons primaires et par les électrons dispersés, caractérisé en ce que le dispositif d'optique-électronique est une lentille (8) qui comprend au moins deux diaphragmes annulaires (13, 14 ou 16, 17, 18) dont le diaphragme-électrode (14 ou 18) voisin de l'échantillon présente le potentiel de la terre afin de maintenir l'échantillon pratiquement exempt de champ.

2. Dispositif selon la revendication 1, caractérisé en ce que la lentille d'optique électronique (8) est formée par trois diaphragmes annulaires (16, 17, 18) dont ceux situés à l'extérieur (16, 18) présentent le potentiel de la terre.

3. Dispositif selon la revendication 1 ou 2, caractérisé en ce que la grandeur des ouvertures centrales des diaphragmes annulaires (13, 14 ou 16, 17, 18) augmente à partir de l'échantillon (5).

FIG.1

FIG.2

FIG. 3

FIG. 4